(19) Europäisches Patentamt

European Patent Office

Office européen des brevets

(11) Publication number: **0 346 776**
**A1**

(12) **EUROPEAN PATENT APPLICATION**

(21) Application number: **89110495.2**

(22) Date of filing: **09.06.89**

(51) Int. Cl.⁴: **G11B 20/14 , H03M 5/02**

(30) Priority: **14.06.88 US 206407**

(43) Date of publication of application:
**20.12.89 Bulletin 89/51**

(84) Designated Contracting States:
**ES**

(71) Applicant: **EASTMAN KODAK COMPANY**
**343 State Street**
**Rochester New York 14650(US)**

(72) Inventor: **Wash, Michael Lee c/o EASTMAN**
**KODAK COMPANY**
**Patent Department 343 State Street**
**Rochester New York 14650(US)**

(74) Representative: **Blickle, K. Werner, Dipl.-Ing. et**
**al**
**KODAK AKTIENGESELLSCHAFT Postfach**
**600345**
**D-7000 Stuttgart-Wangen 60(DE)**

(54) **Three-part decoder circuit.**

(57) Electrical circuit suitable for decoding a binary data stream that has been encoded in a sequential bitcell code format, the encoding resulting in an encoded signal waveform that carries clock information and data information, which electrical circuit comprises: a) a separator means (i) for inputting the encoded signal waveform and separating the clock information from the data information, and (ii) for generating an output clock signal and an output data signal, for each of a succession of bitcells; b) a clock signal integrator for calculating the duration of the bit cell; c) a circuit integrator for determining the center of the bitcell; d) a comparer means for: (i) determining in which part of the bitcell is the data signal, (ii) assigning the decoded signal a first valuation if the data signal is in the first part of the bitcell, and a second valuation if the data signal is in the second part of the bitcell. This circuit preserves the self clocking, velocity insensitive features of the code format.

FIG. 2

## THREE-PART DECODER CIRCUIT

### CROSS-REFERENCE TO A RELATED APPLICATION

This application is related to Application Ser. No. 206,646 filed June 14, 1988, by Wash, Application Ser. No. 206,408 filed June 14, 1988, by Whitfield et al., and Application Ser. No. 206,553 filed June 14, 1988, by Whitfield, which Applications are being filed contemporaneously with this application. The entire disclosures of each of these applications are incorporated by reference herein. Each of these applications is copending and commonly assigned.

### FIELD OF THE INVENTION

This invention relates to electrical circuits suitable for decoding an encoded binary data stream.

### INTRODUCTION TO THE INVENTION

A novel method for modulating a binary data stream into a code format suitable for encoding and decoding e.g., magnetic or optical information, is disclosed in the above-cited Application Ser. No. 206,646 to Wash. The novel method features self-clocking, velocity insensitive encoding and decoding. The Wash disclosure states that preferred electrical circuits that may be employed for realizing the decoding scheme set forth in that disclosure are provided in the present application. This application, therefore, provides novel electrical circuits that may be advantageously employed, for example, in decoding an encoded binary data stream. In particular, the novel electrical circuits include analog circuitry, and are preferably employed to decode magnetic information or data that has been encoded in a three-part-cell code format in accordance with the Wash disclosure. The novel electrical circuits decode the encoded data, and preserve the self-clocking, velocity insensitive features of the novel method.

### SUMMARY OF THE INVENTION

In one aspect, the invention provides an electrical circuit suitable for decoding a binary data stream that has been encoded in a sequential bitcell code format, the encoding resulting in an encoded signal waveform that carries clock information and data information, which electrical circuit comprises:

a) a separator means

(i) for inputting the encoded signal waveform and separating the clock information from the data information, and

(ii) for generating an output clock signal (CS) and an output data signal, for each of a succession of bitcells;

b) a clock signal integrator

(i) for inputting the clock signal for each of the succession of bitcells, and for each of the bitcells,

(ii) integrating the clock signal (CS) in accordance with the function

$\int_{t_0}^{t_1} CS\, dt$, where

$t_0$ = the time of the beginning of a bitcell, as determined by the inputting of a first clock signal

$t_1$ = the time of the end of that bitcell, as determined by the inputting of a sequential clock signal, and

(iii) generating an integrated output signal that indicates the time duration $t_i$, where $t_i = t_1 - t_0$, of that bitcell;

c) a circuit integrator means

(i) for inputting the integrated output signal of each bitcell,

(ii) for generating the parameter

$$\frac{t_i}{2}$$

and

(iii) outputting the parameter

$$\frac{t_i}{2};$$

and

d) a comparer means
(i) for inputting the data signal for each of a succession of bitcells,
(ii) for inputting the parameter

$$\frac{t_i}{2}$$

for each of a succession of bitcells,
(iii) for inputting the integrated output signal, and
(iv) (a) comparing the integrated output signal for each bitcell with the preceding bitcell's parameter

$$\frac{t_i}{2},$$

at the time of the data signal, and
(b) assigning a decoded signal a first valuation if the integrated output signal is less than

$$\frac{t_i}{2},$$

and a second valuation if the integrated output signal is more than

$$\frac{t_i}{2}.$$

As mentioned above, the novel electrical circuit as defined preserves the self-clocking, velocity insensitive features of the Wash method for encoding the decoding information. This preservation factor is provided by the electrical circuit in the following way. In the general case for a sequential bitcell code format inputting into the electrical circuit, the time $t_i$ between two adjacent clock transitions of a first bitcell may differ from the time $t_j$ between two adjacent clock transitions of a second bitcell. This is a consequence of the information transfer rate being dependent on unpredictable and variable transfer rate velocities and accelerations. The present electrical circuit accommodates such unpredictable and variable transfer rates by way of e.g., the clock signal integrator, which integrates over a variable path length $t_0$ to $t_1$, the variable path length therefore accommodating the variable times $t_i$, $t_j$. At the same time, the circuit integrator means generates the parameter

$$\frac{t_i}{2},$$

which is a measure of an instantaneous bitcell half way point. In other words, the circuit integrator means also acts in cooperation with the other elements, to the end of accommodating the variable sequential bitcell

times, $t_i$, $t_j$. Finally, the comparer means acts in cooperation with the clock signal integrator and the circuit integrator means, by acting upon the varying time location data signal in coordination with the variable sequential bitcell times, $t_i$, $t_j$.

I now turn to preferred aspects of the electrical circuit as defined.

Preferably, the separator means separates the encoded signal waveform in accordance with the method of encoding, and subsequent reading of the encoded signal waveform.

To this end, the separator means preferably comprises:

a) a first detector for detecting the encoded signal waveform for the clock information, and

b) a second detector for detecting the encoded signal waveform for the data information, the second detector being connected in parallel with the first detector.

An encoded signal waveform preferably encodes data information by assigning it a positive polarity, and on the other hand, encodes clock information by assigning it a negative polarity. The separator means, accordingly, preferably separates the clock information from the data information by detecting waveform peaks i.e., positive pulses or data information, the waveform valleys i.e., negative pulses or clock information. The separator means operates on a succession of bitcells, and preferably generates an output pulse train that represents the sequential clock signals, and an output pulse train that represents the sequential data signals.

The clock signal integrator preferably comprises a capacitor circuit. Energy stored and released by the capacitor circuit for each bitcell can provide a measure of the integrated output signal, and a measure of the duration $t_i$ of each bitcell.

The circuit integrator means preferably integrates the integrated output signal, in order to provide a time average

$$\frac{t_i}{2} \, ,$$

for each bitcell.

The comparer means preferably comprises a computer, although it may comprise e.g., a shift register circuit, or flip-flop logic circuit.

In another aspect, the invention provides an electrical circuit suitable for decoding a binary data stream that has been encoded by a three-part code method, which method comprises:

(1) defining a bitcell as the time $t_i$ between two adjacent clock transitions;

(2) writing a first clock transition at the beginning of the bitcell; and

(3) encoding a binary data transition after the first clock transition in the ratio of

$$\frac{t_d}{t_i} \, ,$$

where $t_d$ is the time duration between the first clock transition and the data transition, with the proviso that the ratio distinguishes a data 0 bit from a data 1 bit; the electrical circuit comprising:

a) means for determining the time $t_d$ between a first clock transition and the data transition; and

b) means for comparing the time $t_d$ to the variable bitcell time $t_i$.


BRIEF DESCRIPTION OF THE DRAWINGS


The invention is illustrated in the accompanying drawing, in which

FIGS. 1a-g provide signal waveforms that explain the operation of the invention, and

FIGS. 2, 3 and 4 show electrical circuits of the invention.


DETAILED DESCRIPTION OF THE INVENTION

Important aspects of the Wash application Ser. No.206,646, which discloses the novel method for encoding and decoding binary information, are first reviewed from a perspective that will facilitate a clear understanding of the electrical circuits of the present invention. In one aspect, the novel method comprises

(1) defining a bitcell as the time $t_i$ between two adjacent clock transitions;

(2) writing a first clock transition at the beginning of the bitcell; and

(3) encoding a binary data transition after the first clock transition in the ratio of

$$\frac{t_d}{t_i},$$

where $t_d$ is the time duration between the first clock transition and the data transition, with the proviso that

$$\frac{t_d}{t_i} \neq \frac{1}{2}.$$

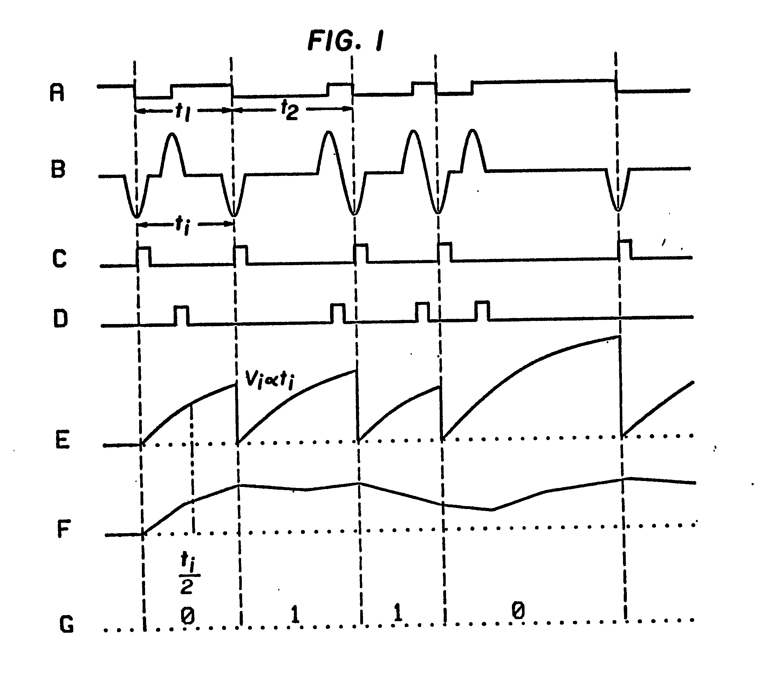

Information that has been encoded pursuant to this method may have an encoded waveform exemplified by FIG. 1a. FIG. 1a shows a sequence of bitcells. Each bitcell is defined by a variable time $t_i$ between two adjacent clock transition pulses. Within each bitcell, a data 0 bit or a data 1 bit has been encoded in accordance with the ratio

$$\frac{t_d}{t_i},$$

as defined. For illustration purposes, a data 0 bit has been encoded by the ratio

$$\frac{t_d}{t_i} < \frac{1}{2},$$

and a data 1 bit has been encoded by the ratio

$$\frac{t_d}{t_i} > \frac{1}{2}.$$

As is well known to those skilled in the art, the method of decoding the encoded waveform of magnetic systems first requires the employment of a magnetic reader. The magnetic reader, in turn, may provide a time derivative encoded waveform of that shown in FIG. 1A. This time derivative encoded waveform is shown in FIG. 1B. Observe that FIG. 1B shows an analog encoded waveform, comprising (albeit in a different form from FIG. 1A) the clock information mixed in with the data information. In particular, FIG. 1B shows that each bitcell is defined by the variable time $t_i$, and that the clock information comprises negative pulses or valleys, and that the data information comprises positive pulses or peaks.

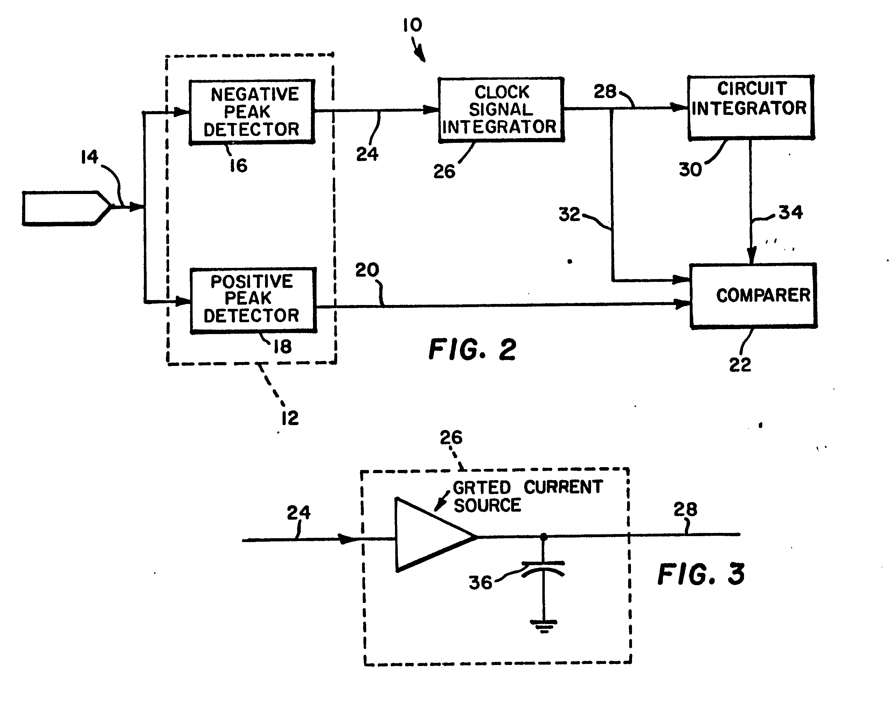

Turning again to the Wash method, we are informed that the encoded waveform of FIG. 1B may be decoded by the step of determining the time between the first clock transition and the data transition, and comparing this time to the variable bitcell time $t_i$. Preferred circuitry for realizing this step is shown in FIG. 2.

FIG. 2 shows an electrical circuit 10 suitable for decoding the encoded signal waveform that carries clock information and data information i.e., the waveform of FIG. 1B. The structure of the electric circuit 10 is as follows. The electrical circuit 10 comprises a separator means 12 that receives the encoded signal waveform along a line 14. The separator means 12, in turn, comprises a negative peak detector 16, and a positive peak detector 18 connected in parallel with the negative peak detector 16. Continuing, the positive peak detector 18 is connected in series along a line 20 to a comparer means 22. The negative peak detector 16, on the other hand, is connected in series along a line 24 to a clock signal integrator 26. The clock signal integrator 26, in turn, is connected in series along a line 28, to a circuit integrator means 30, and to the comparer means 22 along a line 32. Finally, the circuit integrator means 30 is connected in

EP 0 346 776 A1

series to the comparer means 22 along a line 34.

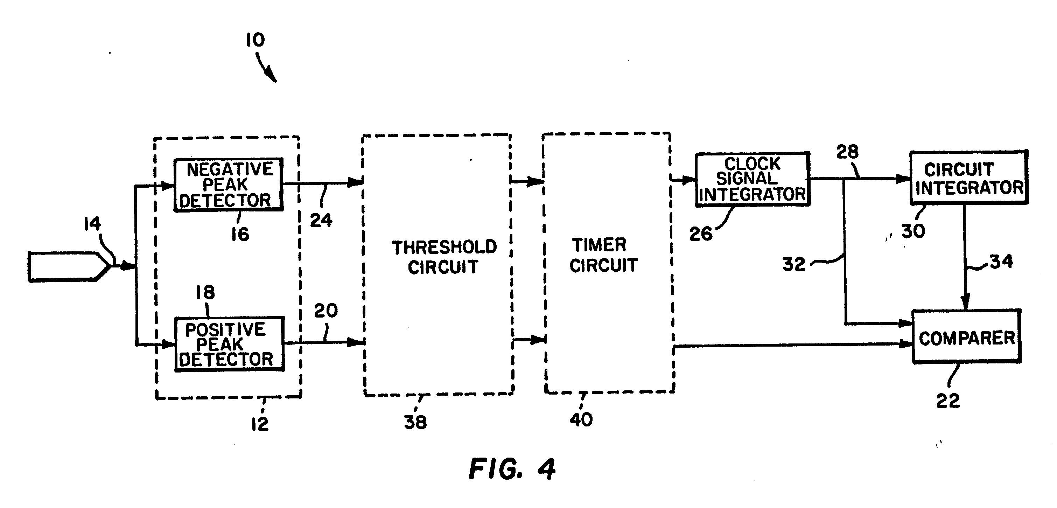

The operation of the FIG. 2 electrical circuit 10 is now explained, with continued reference to the signal waveforms shown in FIG. 1, and with subsequent reference to FIGS. 3 and 4.

To begin, the encoded waveform comprising clock information mixed in with the data information (FIG. 1B), is provided as an input along the line 14 to the separator means 12. The separator means 12 provides an output clock signal (CS) and an output data signal, for each of a succession of bitcells. In particular, the separator means 12 accomplishes this by way of the negative peak detector 16, that detects the encoded signal waveform for clock-information, and the positive peak detector 18, that detects the encoded signal waveform for data information. In particular, the negative peak detector 16 detects the encoded signal waveform for valleys, or negative pulses, and the positive peak detector 18 detects the encoded signal waveform for peaks, or positive pulses. The detector 16 outputs a clock signal (CS) pulse train (see FIG. 1C) for input along the line 24 to the clock signal integrator 26. The detector 18, on the other hand, outputs a data signal pulse train (see FIG. 1D) for input to the comparer means 22 along the line 20.

Treatment of the data signal pulse train in the comparer means 22 is disclosed below. For now, we turn to the continued analysis of the clock signal pulse train as it is inputted to the clock integrator 26. The clock integrator 26 functions to integrate the clock signal pulse train shown in FIG. 1C, to the effect of generating an integrated output signal shown in FIG. 1E. FIG. 1E shows sequential expotential waveforms, where any one expotential waveform corresponds to a bitcell having a variable time $t_i$. For each sequential expotential waveform, $t_i$ is defined as the time of the end of a bitcell ($t_1$), minus the time of the beginning of the bitcell ($t_0$). The objective of the clock integrator 26 is to provide a measure of this time $t_i$ defined by each bitcell. In a preferred embodiment shown in FIG. 3, the clock integrator 26 comprises a capacitor circuit 36. The capacitor circuit 36 comprises a capacitor C connected to ground, and driven by a current source (IS). Energy stored and released by the capacitor circuit 36, as gauged by variable voltage potentials $V_i$, provides a measure of the time $t_i$ defined by each bitcell. The variable voltage potentials $V_i$ are shown in FIG. 1E. The determinant for initiating and concluding capacitor circuit energy storage and release is the advent of sequential clock signal pulses.

The clock integrator 26, accordingly, generates an integrated output signal that indicates the time duration $t_i$ for each bitcell. This integrated output signal, in turn, is inputted to the comparer means 22 along the line 32. Also, the clock integrator 26 outputs the integrated output signal, for input to the circuit integrator means 30 along the line 28. The circuit integrator means 30 functions to integrate the Fig. 1E integrated output signal, to the effect of generating the parameter

$$\frac{t_i}{2}$$

for each bitcell, as shown in FIG. 1F. The importance of the parameter

$$\frac{t_i}{2},$$

and hence of the circuit integrator means 30, is that it provides an indication of the half way point of each bitcell. In particular, the circuit integrator means 30 uses the parameter

$$\frac{t_i}{2}$$

as a projected estimate of the bitcell time

$$\frac{t_i}{2}$$

of a sequential bitcell.

If we now recall the Wash method decoding step, namely, determining the time between the first clock transition and the data transition, and comparing this time to the variable bitcell time $t_i$, it is clear that the electrical circuit 10 has provided all the necessary information in order to finally realize the decoding step in

6

the comparer means 22. The comparer means 22, it is recalled, inputs the data signal pulse train (Fig. 1D) along the line 20, inputs the parameter

$$\frac{t_i}{2}$$

along the line 34, and also inputs the integrated output signal along the line 32. The comparer means 22 compares the data signal for each bitcell, with the previous bitcell's parameter

$$\frac{t_i}{2}.$$

The comparer means 22 assigns a decoded signal a first valuation if the data signal is less that

$$\frac{t_i}{2},$$

and a second valuation if the data signal is greater than

$$\frac{t_i}{2}.$$

It is helpful to restate the operation of the comparer means 22, with reference to FIG. 1G. FIG. 1G shows decoded information for sequential bitcells. (Note that sequential bitcells may be demarked by comparing FIG. 1G to the FIG. 1C clock signal pulse train). Each FIG. 1G bitcell, according to the Wash method, is defined by a variable time $t_i$. This time, $t_i$, is known by the comparer means 22, since it knows the parameter

$$\frac{t_i}{2},$$

for each previous bitcell. The comparer means 22, in the same way, knows the time of the beginning of a bitcell $t_o$, the time of the end of that bitcell, $t_1$ and the variable time $t_i$ defined by that bitcell. The comparer means 22 also receives a data signal along the line 20. The comparer means 22, accordingly, at the time of the receipt of the data signal, assigns the decoded signal a first valuation if the data signal is less than the known parameter

$$\frac{t_i}{2},$$

and a second valuation if the data signal is greater than

$$\frac{t_i}{2}.$$

Recall from above that for purposes of illustration in FIG. 1a, we encoded the data signal a first valuation less than the parameter

$$\frac{t_i}{2},$$

equal to a data 0 bit, and the data signal a second valuation greater than the parameter

$$\frac{t_i}{2}$$

equal to a data 1 bit. The comparer means 22, accordingly, provides information that is a decoding of the data contained in the FIG. 1A waveform, namely, the FIG. 1G. In FIG. 1G, a logic transition initiated by the data signal, sensed by the comparer means 22, occurring before

$$\frac{t_i}{2} \, ,$$

signifies a data 0 bit. On the other hand, a logic level transition initiated by the data signal, sensed by the comparer means 22, and occurring after

$$\frac{t_i}{2} \, ,$$

signifies a data 1 bit.

In a preferred embodiment, the comparer means 22 comprises a computer. A suitable program run by the computer to realize the operation of the comparer means 22, is listed below.

To this end, the following preliminary steps are taken. Two external analog-to-digital (A/D) converters are provided. The A/D outputs are connected to a Port A and to a Port B in the computer. Port A is dedicated to the integrated output signal (IOS) provided on line 32, while the Port B is dedicated to the output of the circuit integrator means 30 on line 34. The data signal pulse train on line 20 is also supplied to the computer, by way of a Port C. A suitable program, written in BASIC, is now listed:

```
START:

DATA1:  INPUTC                          INPUT PORT C
        IF NOT INPUTC THEN GOTO DATA1   WAIT FOR DATA PULSE

DECODE:  INPUTA                         INPUT IOS
         INPUTB                         INPUT vi/2

         IF INPUTA > INPUTB THEN BIT = 1
         IF INPUTA < INPUTB THEN BIT = 0

DATA2:  INPUTC                          INPUT PORT C
        IF INPUTC THEN GOTO DATA2       WAIT FOR DATA PULSE TO
                                        RESET

GOTO DATA1                              DEECODE NEXT DATA BIT

END
```

The output in the program example is a variable named "BIT". If the data signal pulse occurs in the second half of a bitcell, the variable named "BIT" is assigned a data 1. Similarly, if the data signal pulse occurs in the first half of a bitcell, the variable named "BIT" is assigned a data 0.

Attention is now directed to FIG. 4, which shows the electrical circuit 10 of FIG. 2, as well as a threshold circuit 38 and a timer circuit 40. The threshold circuit 38 is connected, as shown, between the separator means 12 and the clock signal integrator 26. The threshold circuit 38 is preferably employed e.g., to suppress noise embedded in the FIG. 1B waveform, to minimize the effects of amplitude changes in the FIG. 1B waveform, and/or to provide a digital variant of the FIG. 1B waveform. The timer circuit 40, on the other hand, connected as shown between the threshold circuit 38, the clock signal integrator 26 and the data comparer means 22, preferably is employed to address the following problem. In operation, the

8

electrical circuit 10 may input sequential bitcells of unacceptably long duration. Or, a sequential bitcell string may simply come to an end. In either case, the timer circuit 40 may be used to disable further input to the clock signal integrator 26 and the comparer means 22 after a preselected interval.

The operation of the electrical circuit 10 has been predicated on the following criteria:

(1) the FIG. 1A clock transitions are the opposite polarity of the data transition. In particular, the clock transitions are positive; the data transition is negative. In other circuit embodiments, not shown, these polarities may be reversed, while still uniquely differentiating the clock transitions from the data transition. Recall that this feature provides self-clocking, which, in turn, permits velocity insensitive encoding and decoding.

(2) the FIG. 1A, for the purposes of illustration, and pursuant to the Wash method, encodes a data 1 bit logic transition at the 1 time location, and a data 0 bit logic transition at the 0 time location (see the Whitfield et al. Application for more details on this encoding realization). In other circuit embodiments, not shown, these locations may be reversed.

(3) the circuit 10 preferably employs a capacitor circuit 36 to provide clock signal integration. In other circuit embodiments, not shown, inductive circuits may be employed in their stead, the inductive circuits accordingly providing time differentiation of the FIG. 1C waveform.

(4) the circuit 10 makes use of e.g., separator means, clock integrators, computers and timer circuits. Conventional such components can be used for this purpose.

(5) with respect to sub-paragraphs 1 to 4, as well as the entire disclosure, those skilled in the art will have no difficulty, having regard to the disclosure herein and their own knowledge, in making and using the invention and in obtaining the advantages of the various embodiments.

## Claims

1. An electrical circuit suitable for decoding a binary data stream that has been encoded in a sequential bitcell code format, the encoding resulting in an encoded signal waveform that carries clock information and data information, which electrical circuit is characterized by

a) a separator means (12) for inputting the encoded signal waveform and separating the clock information from the data information, and for generating an output clock signal (CS) and an output data signal, for each of a succession of bitcells;

b) a clock signal integrator (26) for inputting the clock signal for each of the succession of bitcells, and for each of the bitcells, integrating the clock signal (CS) in accordance with the function
$\int_{t_0}^{t_1} CS\, dt$, where

$t_0$ = the time of the beginning of a bitcell, as determined by the inputting of a first clock signal

$t_1$ = the time of the end of that bitcell, as determined by the inputting of a sequential clock signal, and generating an integrated output signal that indicates the time duration $t_i$, where $t_i = t_1 - t_0$, of that bitcell;

c) a circuit integrator means (30) for inputting the integrated output signal of each bitcell, for generating the parameter

$$\frac{t_i}{2}$$

and outputting the parameter

$$\frac{t_i}{2} \; ;$$

and

d) a comparer means (22) for inputting the data signal for each of a succession of bitcells, for inputting the parameter

$$\frac{t_i}{2}$$

for each of a succession of bitcells, and for inputting the integrated output signal, and comparing the integrated output signal for each bitcell with the preceding bitcell's parameter

$$\frac{t_i}{2},$$

at the time of the data signal, and assigning a decoded signal a first valuation if the integrated output signal is less than

$$\frac{t_i}{2},$$

and a second valuation if the integrated output signal is more than

$$\frac{t_i}{2}.$$

2. An electrical circuit according to claim 1, wherein the separator means (12) comprises:
    a) a first detector (16) for detecting the encoded signal waveform for the clock information, and
    b) a second detector (18) for detecting the encoded signal waveform for the data information, the input to the second detector being connected in parallel with the input to the first detector.

3. An electrical circuit according to claim 1, wherein the clock signal integrator (26) comprises a capacitor circuit (36).

4. An electrical circuit according to claim 1, wherein the circuit integrator means (30) integrates the clock signal integrator's output signal.

5. An electrical circuit according to claim 1, wherein the comparer means (22) comprises a computer.

6. An electrical circuit suitable for decoding a binary data stream that has been encoded by a three-part code method, which method comprises:
- defining a bitcell as the time $t_i$ between two adjacent clock transitions;
- writing a first clock transition at the beginning of the bitcell; and
- encoding a binary data transition after the first clock transition in the ratio of

$$\frac{t_d}{t_i},$$

where $t_d$ is the time duration between the first clock transition and the data transition, with the proviso that the ratio distinguishes a data 0 bit from a data 1 bit; the electrical circuit being characterized by
a) means for determining the time $t_d$ between the first clock transition and the data transition; and
b) means for comparing the time $t_d$ to the variable bitcell time $t_i$.

FIG. 1

EP 0 346 776 A1

FIG. 2

FIG. 3

FIG. 4

EP 0 346 776 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | GB-A-1 542 398 (SECRETARY OF STATE FOR DEFENCE LONDON) * page 2, lines 73-93; page 4, lines 18-111; figure 2 * --- | 1,6 | G 11 B 20/14 H 03 M 5/02 |
| A | US-A-3 475 062 (W. B. CRITTENDEN et al.) * column 1; lines 35-38 * --- | 1,6 | |
| A | US-A-4 037 257 (S. V. CHARI) * whole document * --- | 1,6 | |
| A | GB-A-1 484 290 (IBM CORP.) * whole document * ----- | 1,6 | |

TECHNICAL FIELDS SEARCHED (Int. Cl.4)

G 11 B 20/00
H 03 M 5/00
H 04 L 25/00
G 04 F 10/00

The present search report has been drawn up for all claims

| Place of search | Date of completion of the search | Examiner |
|---|---|---|
| BERLIN | 14-09-1989 | CHAUMERON B. |